# EUROPEAN PATENT SPECIFICATION

(11) **EP 4 163 315 B1**
(45) Date of publication and mention of the grant of the patent: **23.04.2025**
(21) Application number: 21864556.2
(22) Date of filing: 17.08.2021
(51) Int. Cl.: C08G 61/12, C08L 65/00, H10K 85/10, H10K 50/10

(54) **POLYMER, COATING COMPOSITION COMPRISING SAME, AND ORGANIC LIGHT-EMITTING ELEMENT USING SAME**
POLYMER, BESCHICHTUNGSZUSAMMENSETZUNG DAMIT UND ORGANISCHES LICHTEMITTIERENDES ELEMENT DAMIT
POLYMÈRE, COMPOSITION DE REVÊTEMENT LE COMPRENANT, ET ÉLÉMENT ÉLECTROLUMINESCENT ORGANIQUE L'UTILISANT

(30) Priority: 02.09.2020 KR 20200111664
(43) Date of publication of application: 12.04.2023
(73) Proprietor: LG Chem, Ltd., Seoul 07336 (KR)
(72) Inventor: KIM, Juhwan, Daejeon 34122 (KR); BAE, Jaesoon, Daejeon 34122 (KR); LEE, Jaechol, Daejeon 34122 (KR); WOO, Yu Jin, Daejeon 34122 (KR); JUNG, Sejin, Daejeon 34122 (KR); KIM, Ji Hoon, Daejeon 34122 (KR); KHIM, Dongyoon, Daejeon 34122 (KR)
(74) Representative: Hoffmann Eitle
(86) International application number: PCT/KR2021/010854
(87) International publication number: WO 2022/050595

(56) References cited:
- EP-A1- 3 263 622
- WO-A1-2020/065926
- JP-A- 2012 126 813
- KR-A- 20130 021 446
- KR-A- 20160 131 947
- KR-A- 20170 125 053
- US-A1- 2016 329 497
- AGARWALA POOJA ET AL: "A review on triphenylamine (TPA) based organic hole transport materials (HTMs) for dye sensitized solar cells (DSSCs) and perovskite solar cells (PSCs): evolution and molecular engineering", JOURNAL OF MATERIALS CHEMISTRY A, vol. 5, no. 4, 1 January 2017 (2017-01-01), GB, pages 1348 - 1373, XP093089820, ISSN: 2050-7488, DOI: 10.1039/C6TA08449D
- LIU, J. ET AL.: "White Electroluminescence from a Star-like Polymer with an Orange Emissive Core and Four Blue Emissive Arms", ADVANCED MATERIALS., vol. 20, no. 7, 2008, pages 1357 - 1362, XP055907601, DOI: 10.1002/adma.200701705

## Description

### [Technical Field]

The present specification relates to a polymer, a coating composition including the same, and an organic light emitting device formed using the same.

### [Background Art]

An organic light emission phenomenon is one of examples converting a current to visible light by an internal process of specific organic molecules. A principle of an organic light emission phenomenon is as follows. When an organic material layer is placed between an anode and a cathode and a current is applied between the two electrodes, electrons and holes are injected to the organic material layer from the cathode and the anode, respectively. The holes and the electrons injected to the organic material layer recombine to form excitons, and light emits when these excitons fall back to the ground state. An organic electroluminescent device using such a principle may be generally formed with a cathode, an anode, and an organic material layer placed therebetween, for example, an organic material layer including a hole injection layer, a hole transfer layer, a light emitting layer, an electron transfer layer, an electron injection layer and the like.

Materials used in an organic light emitting device are mostly pure organic materials or complex compounds in which organic materials and metals form complexes, and may be divided into a hole injection material, a hole transfer material, a light emitting material, an electron transfer material, an electron injection material and the like depending on the application. Herein, as the hole injection material or the hole transfer material, organic materials having a p-type property, that is, organic materials readily oxidized and having an electrochemically stable state when oxidized, are generally used. Meanwhile, as the electron injection material or the electron transfer material, organic materials having an n-type property, that is, organic materials readily reduced and having an electrochemically stable state when reduced, are generally used. As the light emitting material, materials having both a p-type property and an n-type property, that is, materials having a stable form in both oxidized and reduced states, are preferred, and materials having high light emission efficiency converting, when excitons are formed, the excitons to light are preferred.

A deposition process has been mainly used in the art to manufacture an organic light emitting device. However, manufacturing an organic light emitting device using a deposition process has problems in that it causes much material loss and manufacturing a large area device is difficult, and a device using a solution process has been developed in order to resolve these problems.

Accordingly, materials for a solution process have been developed, and development of materials having, while having superior solubility for organic solvents, suitable viscosity when dissolved in solvents has been required.

### Prior Art Documents

(Patent Document 1) Korean Patent Application Laid-Open Publication No. 10-2008-012337
(Patent Document 2) European Patent Application Laid-Open Publication No. 3263622

### [Disclosure]

### [Technical Problem]

The present specification is directed to providing a polymer, a coating composition including the same, and an organic light emitting device formed using the same.

### [Technical Solution]

One embodiment of the present specification provides a polymer including a unit represented by the following Chemical Formula 1. 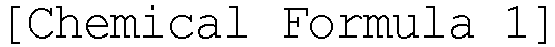 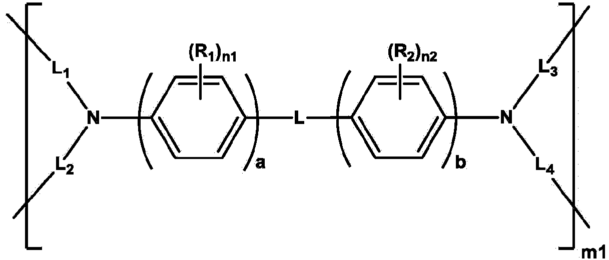 In Chemical Formula 1,
R₁ and R₂ are the same as or different from each other, and each independently hydrogen; deuterium; a halogen group; a substituted or unsubstituted silyl group; a substituted or unsubstituted alkyl group; a substituted or unsubstituted alkoxy group; a substituted or unsubstituted aryl group; or a substituted or unsubstituted heteroaryl group,
L is an arylene group substituted with a C₁-C₃₀ alkyl group; or a heteroarylene group substituted with a C₁-C₃₀ alkyl group,
L₁ to L₄ are the same as or different from each other, and each independently a substituted or unsubstituted arylene group; or a substituted or unsubstituted heteroarylene group,
a and b are each 1 or 2, and when a and b are 2, substituents in the two parentheses are the same as or different from each other,
n1 and n2 are each an integer of 0 to 4, and when n1 and n2 are 2 or greater, substituents in the two or more parentheses are the same as or different from each other, and
m1 is, as a repetition number of the unit, an integer of 1 to 10,000.

Another embodiment of the present specification provides a coating composition including the polymer including the unit represented by Chemical Formula 1 described above.

One embodiment of the present specification provides an organic light emitting device including a first electrode; a second electrode; and an organic material layer provided between the first electrode and the second electrode, wherein the organic material layer includes the polymer including the unit represented by Chemical Formula 1 described above.

In addition, one embodiment of the present specification provides a method for manufacturing an organic light emitting device, the method including preparing a first electrode; forming one or more organic material layers on the first electrode; and forming a second electrode on the one or more organic material layers, wherein the forming of one or more organic material layers includes forming the organic material layers using the coating composition described above.

### [Advantageous Effects]

A unit represented by Chemical Formula 1 according to one embodiment of the present specification has 4 bonding points and is thereby capable of inducing a branch-type polymer form, and has solubility and viscosity for organic solvents suitable for a solution process compared to a linear polymer formed using a unit having two bonding points.

An organic material layer including a polymer according to one embodiment of the present specification has superior hole transfer properties, and an organic light emitting device including the polymer has very enhanced efficiency and lifetime properties.

### [Description of Drawings]

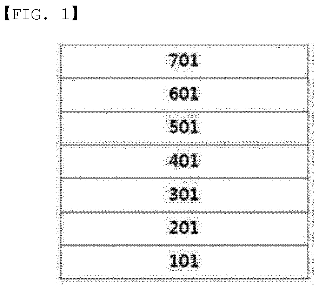

FIG. 1 illustrates an example of an organic light emitting device according to one embodiment of the present specification.

### [Reference Numeral]

101: Substrate
201: First Electrode
301: Hole Injection Layer
401: Hole Transfer Layer
501: Light Emitting Layer
601: Electron Injection and Transfer Layer
701: Second Electrode

### [Mode for Disclosure]

Hereinafter, the present specification will be described in more detail.

One embodiment of the present specification provides a polymer including a unit represented by Chemical Formula 1.

According to one embodiment of the present specification, the polymer including the unit represented by Chemical Formula 1 may include one or more types of the unit represented by Chemical Formula 1.

In one embodiment of the present specification, the polymer including the unit represented by Chemical Formula 1 may include two or more types of the unit represented by Chemical Formula 1. In this case, the polymer including the unit represented by Chemical Formula 1 may be a random copolymer or a block copolymer.

In one embodiment of the present specification, the polymer including the unit represented by Chemical Formula 1 may be a homopolymer. Herein, the homopolymer means a polymer formed with only one type of monomer.

According to one embodiment of the present specification, the polymer including the unit represented by Chemical Formula 1 may include additional units in addition to the unit represented by Chemical Formula 1.

In the present specification, the "unit" is a structure in which a monomer is included and repeated in a polymer, and means a structure in which a monomer bonds in a polymer by polymerization.

In the present specification, the meaning of "including a unit" means the corresponding unit being included in a main chain in a polymer.

In one embodiment of the present specification, the unit represented by Chemical Formula 1 has a structure in which two amines are linked through three or more linking groups and has a repeated structure at 4 bonding points, and as a result, the polymer including the unit represented by Chemical Formula 1 has superior solubility for organic solvents and has proper viscosity for a solution process.

Accordingly, when using the polymer including the unit represented by Chemical Formula 1 in a hole transfer layer, a hole injection layer or a hole injection and transfer layer of an organic light emitting device, the prepared hole transfer layer, hole injection layer or hole injection and transfer layer has superior uniformity, surface properties and the like as well, which may enhance device performance and lifetime properties.

According to one embodiment of the present specification, the unit represented by Chemical Formula 1 may have a repetition number (m1) of 1 to 400, however, the number is not limited thereto.

In one embodiment of the present specification, a material forming a specific organic material layer of an organic light emitting device may be analyzed through MS and NMR analyses after extracting the corresponding organic material layer from the organic light emitting device.

In the present specification, a description of a certain member being placed "on" another member includes not only a case of the one member being in contact with the another member but a case of still another member being present between the two members.

In the present specification, a description of a certain part "including" certain constituents means capable of further including other constituents, and does not exclude other constituents unless particularly stated on the contrary.

Examples of substituents in the present specification are described below, however, the substituents are not limited thereto.

The term "substitution" means a hydrogen atom bonding to a carbon atom of a compound being changed to another substituent. The position of substitution is not limited as long as it is a position at which the hydrogen atom is substituted, that is, a position at which a substituent is capable of substituting, and when two or more substituents substitute, the two or more substituents may be the same as or different from each other.

The term "substituted or unsubstituted" in the present specification means being substituted with one or more substituents selected from the group consisting of deuterium; a halogen group; a hydroxyl group; a cyano group; a silyl group; an alkyl group; a cycloalkyl group; an alkenyl group; an alkoxy group; an aryloxy group; -N(Rm) (Rn); an aryl group; and a heteroaryl group, or being substituted with a substituent linking two or more substituents among the substituents illustrated above, or having no substituents, and Rm and Rn are the same as or different from each other and each independently hydrogen; an alkyl group; an aryl group; or a heteroaryl group. For example, the "substituent linking two or more substituents" may include a biphenyl group. In other words, a biphenyl group may be an aryl group, or interpreted as a substituent linking two phenyl groups.

In the present specification, examples of the halogen group may include fluorine, chlorine, bromine or iodine.

In the present specification, the silyl group may be an alkylsilyl group or an arylsilyl group, and furthermore, may be a trialkylsilyl group or a triarylsilyl group. The number of carbon atoms of the silyl group is not particularly limited, but is preferably from 1 to 30, and the alkylsilyl group may have 1 to 30 carbon atoms and the arylsilyl group may have 6 to 30 carbon atoms. Specific examples thereof may include a trimethylsilyl group, a triethylsilyl group, a tert-butyldimethylsilyl group, a propyldimethylsilyl group, a triphenylsilyl group, a diphenylsilyl group, a phenylsilyl group and the like, but are not limited thereto.

In the present specification, the alkyl group may be linear or branched, and although not particularly limited thereto, the number of carbon atoms is preferably from 1 to 30. Specific examples thereof may include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, 5-methylhexyl and the like, but are not limited thereto.

In the present specification, the cycloalkyl group is not particularly limited, but preferably has 3 to 30 carbon atoms, and specific examples thereof may include cyclopropyl, cyclobutyl, cyclopentyl, cyclohexyl, cycloheptyl, cyclooctyl and the like, but are not limited thereto.

In the present specification, the alkenyl group may be linear or branched, and although not particularly limited thereto, the number of carbon atoms is preferably from 2 to 30. Specific examples thereof may include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group and the like, but are not limited thereto.

In the present specification, the alkoxy group may be linear, branched or cyclic. The number of carbon atoms of the alkoxy group is not particularly limited, but is preferably from 1 to 30. Specific examples thereof may include methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy and the like, but are not limited thereto.

In the present specification, the aryl group is not particularly limited, but may have 6 to 60 carbon atoms, and may have 6 to 30 carbon atoms.

In the present specification, the aryl group may include a structure in which two or more aryl groups are linked. For example, the aryl group may include a biphenyl group in which two phenyl groups are linked, may include a terphenyl group in which three phenyl groups are linked, and may include a binaphthyl group in which two naphthyl groups are linked.

The aryl group may be monocyclic or polycyclic. When the aryl group is a monocyclic aryl group, examples thereof may include a phenyl group, a biphenyl group, a terphenyl group and the like, but are not limited thereto. When the aryl group is a polycyclic aryl group, examples thereof may include a naphthyl group, an anthracene group, a phenanthrene group, a triphenylene group, a pyrene group, a phenalene group, a perylene group, a chrysene group, a fluorenyl group and the like, but are not limited thereto.

In the present specification, the fluorenyl group may be substituted, and adjacent groups may bond to each other to form a ring.

When the fluorenyl group is substituted, the substituted fluorenyl group may be, for example, any one selected from among the following compounds, but is not limited thereto.

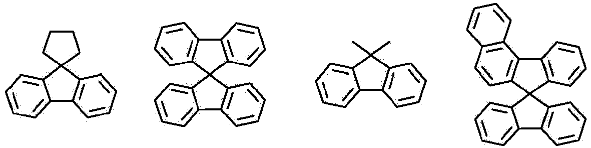

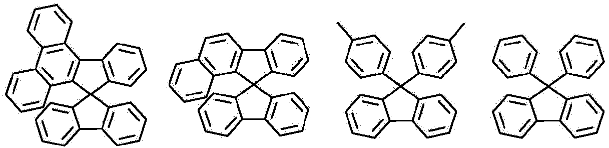

In the present specification, the "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituting ortho positions in a benzene ring, and two substituents substituting the same carbon in an aliphatic ring may be interpreted as groups "adjacent" to each other.

In the present specification, the heteroaryl group includes one or more heteroatoms that are atoms that are not carbon, and specifically, the heteroatom may include one or more atoms selected from the group consisting of O, N, Se and S. The number of carbon atoms thereof is not particularly limited, but is preferably from 2 to 30, and the heteroaryl group may be monocyclic or polycyclic. Examples of the heteroaryl group may include a thiophenyl group, a furanyl group, a pyrrolyl group, an imidazolyl group, a thiazolyl group, an oxazolyl group, an oxadiazolyl group, a pyridinyl group, a bipyridinyl group, a pyrimidinyl group, a triazinyl group, a triazolyl group, an acridinyl group, a pyridazinyl group, a pyrazinyl group, a quinolinyl group, a quinazolinyl group, a quinoxalinyl group, a phthalazinyl group, a pyridopyrimidinyl group, a pyridopyrazinyl group, a pyrazinopyrazinyl group, an isoquinolinyl group, an indolyl group, a carbazolyl group, a benzoxazolyl group, a benzimidazolyl group, a benzothiazolyl group, a benzocarbazolyl group, a benzothiophenyl group, a dibenzothiophenyl group, a benzofuranyl group, a phenanthridinyl group, a phenanthrolinyl group, an isoxazolyl group, a thiadiazolyl group, a phenothiazinyl group, a dibenzofuranyl group and the like, but are not limited thereto.

In the present specification, the aryl group in the aryloxy group is the same as the examples of the aryl group described above. Specific examples of the aryloxy group may include a phenoxy group, a p-tolyloxy group, an m-tolyloxy group, a 3,5-dimethyl-phenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthracenyloxy group, a 2-anthracenyloxy group, a 9-anthryloxy group, a 1-phenanthrenyloxy group, a 3-phenanthrenyloxy group, a 9-phenanthrenyloxy group and the like, but are not limited thereto.

In the present specification, specific examples of - N(Rm) (Rn) may include a methylamine group, a dimethylamine group, an ethylamine group, a diethylamine group, a phenylamine group, a naphthylamine group, a biphenylamine group, an anthracenylamine group, a 9-methyl-anthracenylamine group, a diphenylamine group, a ditolylamine group, an N-phenyltolylamine group, a triphenylamine group, an N-phenylbiphenylamine group, an N-phenylnaphthylamine group, an N-biphenylnaphthylamine group, an N-naphthylfluorenylamine group, an N-phenylphenanthrenylamine group, an N-biphenylphenanthrenylamine group, an N-phenylfluorenylamine group, an N-phenylterphenylamine group, an N-phenanthrenylfluorenylamine group, an N-biphenylfluorenylamine group and the like, but are not limited thereto.

In the present specification, the arylene group means an aryl group having two bonding sites, that is, a divalent group. The descriptions on the aryl group provided above may be applied thereto except that the arylene group is a divalent group.

In the present specification, the heteroarylene group means a heteroaryl group having two bonding sites, that is, a divalent group. The descriptions on the heteroaryl group provided above may be applied thereto except that the heteroarylene group is a divalent group.

Hereinafter, substituents of Chemical Formula 1 will be described.

According to one embodiment of the present specification, R₁ and R₂ are the same as or different from each other, and each independently hydrogen; deuterium; a halogen group; a substituted or unsubstituted silyl group; a substituted or unsubstituted C₁-C₃₀ alkyl group; a substituted or unsubstituted C₁-C₃₀ alkoxy group; a substituted or unsubstituted C₆-C₆₀ aryl group; or a substituted or unsubstituted C₂-C₆₀ heteroaryl group.

According to one embodiment of the present specification, R₁ and R₂ are the same as or different from each other, and each independently hydrogen; deuterium; a halogen group; a substituted or unsubstituted C₁-C₃₀ alkylsilyl group; a substituted or unsubstituted C₁-C₃₀ alkyl group; a substituted or unsubstituted C₁-C₃₀ alkoxy group; a substituted or unsubstituted C₆-C₆₀ aryl group; or a substituted or unsubstituted C₂-C₆₀ heteroaryl group.

According to one embodiment of the present specification, R₁ and R₂ are the same as or different from each other, and each independently hydrogen; deuterium; a halogen group; a C₁-C₂₀ alkylsilyl group; a C₁-C₂₀ alkyl group; a substituted or unsubstituted C₁-C₂₀ alkoxy group; a substituted or unsubstituted C₆-C₃₀ aryl group; or a substituted or unsubstituted C₂-C₃₀ heteroaryl group.

In one embodiment of the present specification, R₁ and R₂ are the same as or different from each other, and each independently hydrogen or a C₁-C₂₀ alkyl group.

According to another embodiment, R₁ and R₂ are the same as or different from each other, and each independently hydrogen or a methyl group.

According to one embodiment of the present specification, L is an arylene group substituted with a C₁-C₃₀ alkyl group; or a heteroarylene group substituted with a C₁-C₃₀ alkyl group. By L having the above-described scope in Chemical Formula 1, effects of enhancing device efficiency and lifetime are obtained when using the polymer including the unit represented by Chemical Formula 1 in an organic light emitting device.

According to one embodiment of the present specification, L is a C₆-C₆₀ arylene group substituted with a C₁-C₃₀ alkyl group; or a C₂-C₆₀ heteroarylene group substituted with a C₁-C₃₀ alkyl group.

According to one embodiment of the present specification, L is a C₆-C₃₀ arylene group substituted with a C₁-C₂₀ alkyl group; or a C₂-C₃₀ O, S or N-containing heteroarylene group substituted with a C₁-C₂₀ alkyl group.

In one embodiment of the present specification, L is a phenylene group substituted with a C₁-C₃₀ alkyl group; a benzofluorenylene group substituted with a C₁-C₃₀ alkyl group; a binaphthylene group substituted with a C₁-C₃₀ alkyl group; a divalent dibenzofuran group substituted with a C₁-C₃₀ alkyl group; a divalent dibenzothiophene group substituted with a C₁-C₃₀ alkyl group; or a divalent carbazolyl group substituted with a C₁-C₃₀ alkyl group.

In one embodiment of the present specification, L is a phenylene group substituted with a hexyl group; a benzofluorenylene group substituted with a hexyl group; a binaphthylene group substituted with an octyl group; or a divalent carbazolyl group substituted with a tridecane group (-C₁₃H₂₇).

In one embodiment of the present specification, L is any one selected from among the following structural formulae.

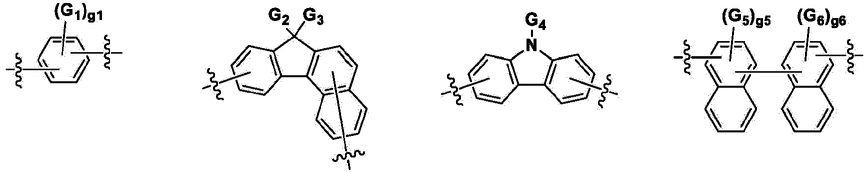

In the structural formulae, 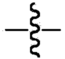 means a linking position,
G1 to G6 are the same as or different from each other, and each independently hydrogen; deuterium; or a C₁-C₃₀ alkyl group,
g1 is an integer of 0 to 4, and when g1 is 2 or greater, the two or more G1s are the same as or different from each other, and
g5 and g6 are each an integer of 0 to 2, and when g5 and g6 are each 2, the two G5s and G6s are the same as or different from each other.

In one embodiment of the present specification, G1 to G6 are the same as or different from each other, and each independently hydrogen; deuterium; or a C₁-C₂₀ alkyl group.

In one embodiment of the present specification, G1 to G6 are the same as or different from each other, and each independently hydrogen; or a C₁-C₂₀ alkyl group.

In one embodiment of the present specification, G1 to G6 are the same as or different from each other, and each independently hydrogen; a hexyl group; an octyl group; or a tridecane group.

In one embodiment of the present specification, G1 is hydrogen; or a hexyl group.

In one embodiment of the present specification, G2 and G3 are a hexyl group.

In one embodiment of the present specification, G4 is a tridecane group.

In one embodiment of the present specification, G5 is an octyl group.

In one embodiment of the present specification, the tridecane group may be branched, and may specifically have a structure of -C(C₆H₁₃)₂.

In one embodiment of the present specification, g1 is from 0 to 2.

In one embodiment of the present specification, g1 is 2.

In one embodiment of the present specification, g5 and g6 are 1.

In one embodiment of the present specification, L is any one selected from among the following structural formulae.

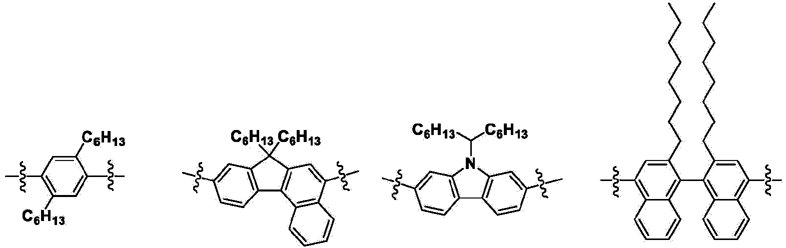

In the structural formulae, 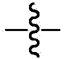 means a linking position.

According to one embodiment of the present specification, L₁ to L₄ are the same as or different from each other, and each independently a substituted or unsubstituted C₆-C₆₀ arylene group; or a substituted or unsubstituted C₂-C₆₀ heteroarylene group.

According to another embodiment, L₁ to L₄ are the same as or different from each other, and each independently a substituted or unsubstituted biphenylylene group; or a substituted or unsubstituted terphenylene group.

In another embodiment, L₁ to L₄ are the same as or different from each other, and each independently a biphenylylene group unsubstituted or substituted with a C₁-C₃₀ alkyl group; or a terphenylene group unsubstituted or substituted with a C₁-C₃₀ alkyl group.

In another embodiment, L₁ to L₄ are the same as or different from each other, and each independently a biphenylylene group; or a terphenylene group unsubstituted or substituted with a propyl group.

In another embodiment, L₁ to L₄ are the same as or different from each other, and each independently a biphenylylene group; or a terphenylene group unsubstituted or substituted with a propyl group.

In another embodiment, L₁ to L₄ are the same as or different from each other, and each independently represented by any one of the following structural formulae.

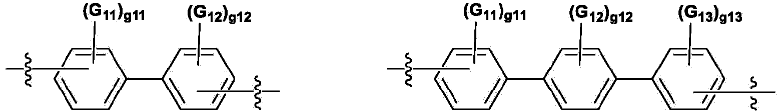

In the structural formulae, 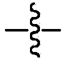 means a linking position,
G₁₁ to G₁₃ are the same as or different from each other, and each independently hydrogen, deuterium or a C₁-C₃₀ alkyl group, and
g11 to g13 are each an integer of 0 to 4, and when g11 to g13 are 2 or greater, structures in the parentheses are each the same as or different from each other.

In one embodiment of the present specification, G₁₁ to G₁₃ are the same as or different from each other, and each independently hydrogen or a propyl group.

In one embodiment of the present specification, G₁₁ and G₁₂ are hydrogen.

In one embodiment of the present specification, G₁₃ is hydrogen or a propyl group.

In one embodiment of the present specification, G₁₃ is a propyl group.

In one embodiment of the present specification, g11 and g12 are each an integer of 1 to 4.

In one embodiment of the present specification, g13 is 2.

In one embodiment of the present specification, a and b are 1.

In one embodiment of the present specification, n1 and n2 are each 0 or 1.

In another embodiment, L₁ to L₄ are the same as or different from each other, and each independently represented by any one of the following structural formulae.

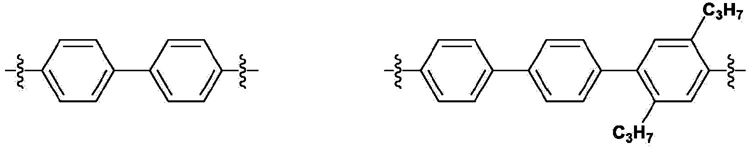

In the structural formulae, 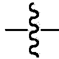 means a linking position.

In one embodiment of the present specification, m1 is, as a repetition number of the unit, an integer of 1 to 10,000.

In another embodiment, m1 is, as a repetition number of the unit, an integer of 5 to 5,000.

In another embodiment, m1 is, as a repetition number of the unit, an integer of 5 to 1,000.

In another embodiment, m1 is, as a repetition number of the unit, an integer of 10 to 300.

According to one embodiment of the present specification, the unit represented by Chemical Formula 1 is any one selected from among the following structures.

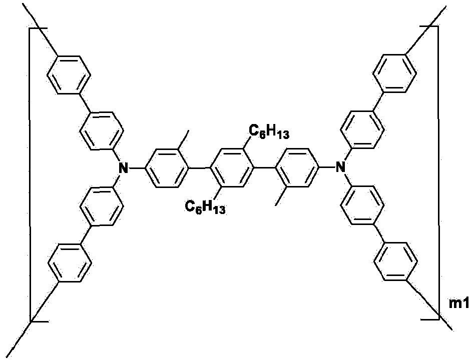

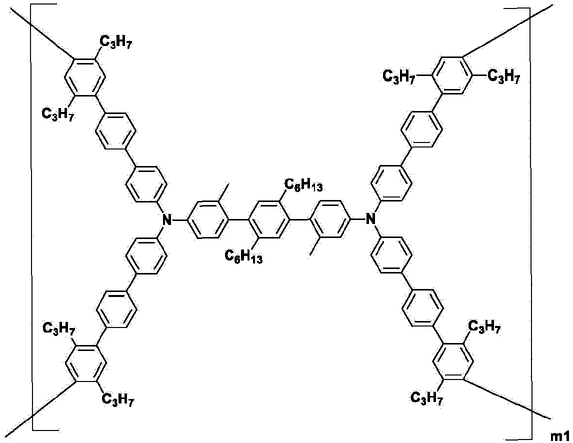

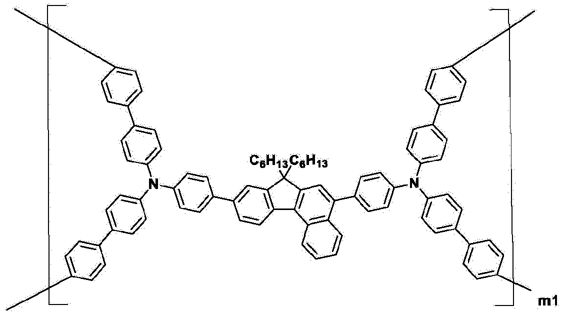

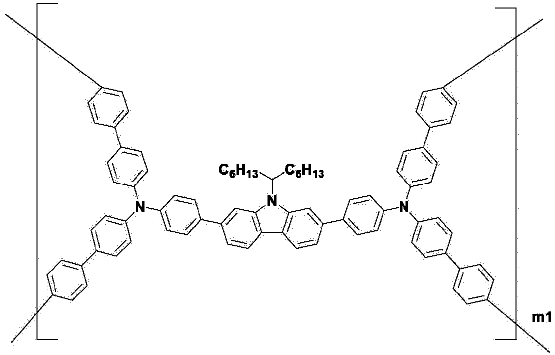

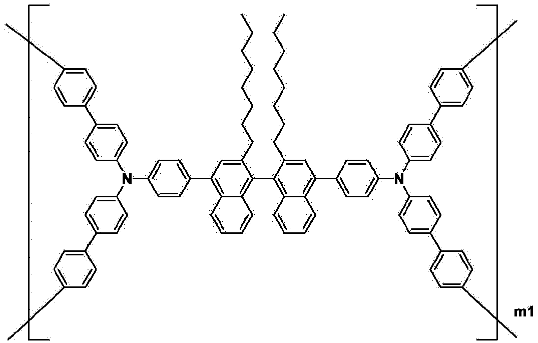

In the structures,
m1 is, as a repetition number of the unit, an integer of 1 to 10,000.

In the present specification, an end group of the polymer may be hydrogen or an aryl group.

In one embodiment of the present specification, the polymer including the unit represented by Chemical Formula 1 has a number average molecular weight of 500 g/mol to 1,000,000 g/mol, and more preferably 10,000 g/mol to 300,000 g/mol. In another embodiment, the number average molecular weight is from 10,000 g/mol to 100,000 g/mol. When the polymer including the unit represented by Chemical Formula 1 has a number average molecular weight of less than the above-mentioned range, performance of a device aimed in the present disclosure is difficult to obtain, and the number average molecular weight being greater than the above-mentioned range has a problem of reducing solubility of the polymer for a solvent, and therefore, it is preferred to have the molecular weight in the above-mentioned range.

In one embodiment of the present specification, the polymer including the unit represented by Chemical Formula 1 has a weight average molecular weight of 10,000 g/mol to 1,000,000 g/mol, and more preferably 10,000 g/mol to 300,000 g/mol. In another embodiment, the weight average molecular weight is from 20,000 g/mol to 200,000 g/mol.

In one embodiment of the present specification, the polymer may have molecular weight distribution of 1 to 10. Preferably, the polymer has molecular weight distribution of 1 to 4.

In the present specification, the terms number average molecular weight (Mn) and weight average molecular weight (Mw) mean a converted molecular weight for standard polystyrene measured using GPC (gel permeation chromatography). In the present specification, the molecular weight distribution means a number obtained from dividing the weight average molecular weight (Mw) by the number average molecular weight (Mn), that is, weight average molecular weight (Mw)/number average molecular weight (Mn).

The number average molecular weight (Mn) and the molecular weight distribution (PDI) may be measured using GPC (gel permeation chromatography). The target subject to analysis is placed in a 5 mL vial, and diluted in tetrahydrofuran (THF) so as to have a concentration of approximately 1 mg/mL. After that, a standard sample for calibration and the sample to analyze are filtered through a syringe filter (pore size=0.45 µm), and measured. As the analysis program, ChemStation of Agilent Technologies is used, and after obtaining each of the weight average molecular weight (Mw) and the number average molecular weight (Mn) by comparing an elution time of the sample with the calibration curve, molecular weight distribution (PDI) may be calculated from the ratio (Mw/Mn). Measurement conditions of the GPC may be as follows.
Instrument: 1200 series of Agilent Technologies
Column: use two PLgel mixed B of Polymer Laboratories
Solvent: THF
Column temperature: 40°C
Sample concentration: 1 mg/mL, inject 10 microliters
Standard sample: polystyrene (Mp: 3900000, 723000, 316500, 52200, 31400, 7200, 3940, 485)

In one embodiment of the present specification, the polymer including the unit represented by Chemical Formula 1 may have viscosity of 1 cP to 60 cP at room temperature. In another embodiment, the viscosity may be from 1 cP to 40 cP, 2 cP to 20 cP, 2 cP to 12 cP, or 3 cP to 8 cP. In another embodiment, the polymer may have viscosity of 4 cP to 6.5 cP at room temperature.

The viscosity may be measured using a Brookfield viscometer CV Nest Cone & Plate Rheometer while maintaining 25°C. Herein, 1 mL of a sample including the specimen 2 wt% (solvent: toluene) may be used.

When the viscosity of the polymer satisfies the above-mentioned range, viscosity suitable for a solution process is obtained, and a device may be readily manufactured. On the other hand, the polymer viscosity being less than the above-mentioned range causes a fluidity problem making it difficult to use the polymer in the process, and the viscosity being greater than the above-mentioned range may cause a problem in that the polymer may not be used in high-resolution panel manufacturing due to a high viscosity issue.

One embodiment of the present specification provides a coating composition including the polymer including the unit represented by Chemical Formula 1.

According to one embodiment of the present specification, the coating composition may further include a solvent.

In one embodiment of the present specification, the coating composition may be a liquid phase. The "liquid phase" means being in a liquid state at room temperature and atmospheric pressure.

In one embodiment of the present specification, examples of the solvent may include chlorine-based solvents such as chloroform, methylene chloride, 1,2-dichloroethane, 1,1,2-trichloroethane, chlorobenzene or o-dichlorobenzene; ether-based solvents such as tetrahydrofuran or dioxane; aromatic hydrocarbon-based solvents such as toluene, xylene, trimethylbenzene or mesitylene; aliphatic hydrocarbon-based solvents such as cyclohexane, methylcyclohexane, n-pentane, n-hexane, n-heptane, n-octane, n-nonane or n-decane; ketone-based solvents such as acetone, methyl ethyl ketone or cyclohexanone; ester-based solvents such as ethyl acetate, butyl acetate or ethyl cellosolve acetate; polyalcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin or 1,2-hexanediol, and derivatives thereof; alcohol-based solvents such as methanol, ethanol, propanol, isopropanol or cyclohexanol; sulfoxide-based solvents such as dimethyl sulfoxide; amide-based solvents such as N-methyl-2-pyrrolidone or N,N-dimethylformamide; benzoate-based solvents such as methyl benzoate, butyl benzoate or 3-phenoxybenzoate; tetraline, and the like, however, the solvent is not limited thereto as long as it is a solvent capable of dissolving or dispersing the compound according to one embodiment of the present specification.

In another embodiment, the solvent may be used either alone as one type, or as a mixture of two or more solvent types.

In another embodiment, viscosity of the single or mixed solvent is preferably from 1 cP to 10 cP and more preferably from 3 cP to 8 cP at room temperature, but is not limited thereto.

In another embodiment, the coating composition has a concentration of preferably 0.1 wt/v% to 20 wt/v% and more preferably 0.5 wt/v% to 5 wt/v%, however, the concentration is not limited thereto.

In addition, one embodiment of the present specification provides an organic light emitting device formed using the coating composition.

One embodiment of the present specification provides an organic light emitting device including a first electrode; a second electrode; and an organic material layer provided between the first electrode and the second electrode, wherein the organic material layer includes the polymer including the unit represented by Chemical Formula 1 described above.

In one embodiment of the present specification, the first electrode is a cathode, and the second electrode is an anode.

In another embodiment, the first electrode is an anode, and the second electrode is a cathode.

In one embodiment of the present specification, the organic material layer including the polymer including the unit represented by Chemical Formula 1 is an electron blocking layer; a hole transfer layer; a hole injection layer; or a hole injection and transfer layer.

According to one embodiment of the present specification, the organic material layer including the polymer including the unit represented by Chemical Formula 1 is a hole transfer layer.

In another embodiment of the present specification, the organic material layer including the polymer including the unit represented by Chemical Formula 1 is a hole blocking layer; an electron transfer layer; an electron injection layer; or an electron injection and transfer layer.

In one embodiment of the present specification, the organic light emitting device may further include one, two or more layers selected from the group consisting of a hole injection layer; a hole transfer layer; a light emitting layer; an electron transfer layer; an electron injection layer; an electron blocking layer; a hole blocking layer; a hole injection and transfer layer; and an electron injection and transfer layer.

In another embodiment, the organic light emitting device may be an organic light emitting device having a structure in a normal direction in which an anode, one or more organic material layers and a cathode are consecutively laminated on a substrate (normal type).

In another embodiment, the organic light emitting device may be an organic light emitting device having a structure in a reverse direction in which a cathode, one or more organic material layers and an anode are consecutively laminated on a substrate (inverted type).

The organic material layer of the organic light emitting device of the present specification may be formed in a single layer structure, but may be formed in a multilayer structure in which two or more organic material layers are laminated. For example, the organic light emitting device of the present specification may have a structure including a hole injection layer, a hole transfer layer, a light emitting layer, an electron transfer layer, an electron injection layer, an electron blocking layer, a hole blocking layer, a hole injection and transfer layer, an electron injection and transfer layer as the organic material layer. However, the structure of the organic light emitting device is not limited thereto, and may include a smaller number of organic layers.

For example, a structure of the organic light emitting device according to one embodiment of the present specification is illustrated in FIG. 1.

FIG. 1 illustrates a structure of the organic light emitting device in which a first electrode (201), a hole injection layer (301), a hole transfer layer (401), a light emitting layer (501), an electron injection and transfer layer (601) and a second electrode (701) are consecutively laminated on a substrate (101). Herein, the electron injection and transfer layer means a layer carrying out electron injection and electron transfer at the same time.

In one embodiment of the present specification, the hole injection layer (301) or the hole transfer layer (401) of FIG. 1 may be formed using the coating composition including the polymer including the unit represented by Chemical Formula 1.

FIG. 1 illustrates the organic light emitting device, however, the organic light emitting device is not limited thereto.

When the organic light emitting device includes a plurality of organic material layers, the organic material layers may be formed with materials the same as or different from each other.

The organic light emitting device of the present specification may be manufactured using materials and methods known in the art, except that one or more layers of the organic material layers are formed using the coating composition described above.

For example, the organic light emitting device of the present specification may be manufactured by consecutively laminating an anode, an organic material layer and a cathode on a substrate. Herein, the organic light emitting device may be manufactured by forming an anode on a substrate by depositing a metal, a metal oxide having conductivity, or an alloy thereof using a physical vapor deposition (PVD) method such as sputtering or e-beam evaporation, forming an organic material layer including a hole injection layer, a hole transfer layer, a light emitting layer, an electron transfer layer and the like thereon, and then depositing a material capable of being used as a cathode thereon. In addition to such a method, the organic light emitting device may also be manufactured by consecutively depositing a cathode material, an organic material layer and an anode material on a substrate.

The present specification provides a method for manufacturing an organic light emitting device formed using the coating composition. Herein, the coating composition means the coating composition including the polymer including the unit represented by Chemical Formula 1.

One embodiment of the present specification provides a method for manufacturing an organic light emitting device, the method including preparing a first electrode; forming one or more organic material layers on the first electrode; and forming a second electrode on the one or more organic material layers, wherein the forming of one or more organic material layers includes forming the organic material layers using the coating composition including the polymer including the unit represented by Chemical Formula 1 described above.

In the method for manufacturing an organic light emitting device, the forming of organic material layers using the coating composition includes coating the coating composition; and heat treating or light treating the coated coating composition.

In the method for manufacturing an organic light emitting device, the forming of organic material layers using the coating composition includes coating the coating composition on the first electrode or on the one or more organic material layers; and heat treating or light treating the coated coating composition.

In one embodiment of the present specification, the organic material layer formed using the coating composition is formed using spin coating or inkjetting.

In another embodiment, the organic material layer formed using the coating composition is formed using a printing method.

In an embodiment of the present specification, examples of the printing method include inkjet printing, nozzle printing, offset printing, transfer printing, screen printing or the like, but are not limited thereto.

The coating composition according to one embodiment of the present specification is suited for a solution process due to its structural properties and may be formed using a printing method, and therefore, is economically effective in terms of time and costs when manufacturing a device.

In one embodiment of the present specification, in the heat treating or light treating, the time of the heat treatment is preferably within 1 hour and more preferably within 30 minutes.

In one embodiment of the present specification, in the heat treating or light treating, the atmosphere of the heat treatment is preferably an inert gas such as argon or nitrogen.

In one embodiment, when using the coating composition including the polymer including the unit represented by Chemical Formula 1 as the coating composition, the heat treating or light treating of the coated coating composition may be removing the solvent from the coated coating composition.

When the forming of organic material layers using the coating composition includes the heat treating or light treating, an organic material layer including a structure in which the coating composition is thin filmed may be provided. In this case, the organic material layer formed using the coating composition may be prevented from being dissolved by the solvent of the organic material layer on the surface, being morphologically influenced, or being decomposed.

In addition, the organic material layer according to one embodiment of the present specification may include the polymer including the unit represented by Chemical Formula 1 alone, but may also further include other monomers or other polymers.

As the anode material, materials having large work function are normally preferred so that hole injection to an organic material layer is smooth. Specific examples of the anode material usable in the present specification include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or SnO₂:Sb; conductive polymers such as poly(3-methylthiophene), poly[3,4-(ethylene-1,2-dioxy)thiophene] (PEDOT), polypyrrole and polyaniline, and the like, but are not limited thereto.

As the cathode material, materials having small work function are normally preferred so that electron injection to an organic material layer is smooth. Specific examples of the cathode material include metals such as magnesium, calcium, sodium, potassium, titanium, indium, yttrium, lithium, gadolinium, aluminum, silver, tin and lead, or alloys thereof; multilayer structure materials such as LiF/Al or LiO_{2/}Al, and the like, but are not limited thereto.

The hole injection layer is a layer that injects holes from an electrode, and the hole injection material is preferably a compound that has an ability to transfer holes and thereby has a hole injection effect in an anode and an excellent hole injection effect for a light emitting layer or a light emitting material, prevents excitons generated in the light emitting layer from moving to an electron injection layer or an electron injection material, and in addition thereto, has an excellent thin film forming ability. The highest occupied molecular orbital (HOMO) of the hole injection material is preferably in between the work function of an anode material and the HOMO of surrounding organic material layers. Specific examples of the hole injection material include metal porphyrins, oligothiophene, arylamine-based organic materials, hexanitrile hexaazatriphenylene-based organic materials, quinacridone-based organic materials, perylene-based organic materials, anthraquinone, and polyaniline- and polythiophene-based conductive polymers, and the like, but are not limited thereto.

The hole transfer layer is a layer that receives holes from a hole injection layer and transfers the holes to a light emitting layer, and, when the organic light emitting device includes an additional hole transfer layer in addition to the hole transfer layer including the polymer including the unit represented by Chemical Formula 1, materials capable of receiving holes from an anode or a hole injection layer, moving the holes to a light emitting layer, and having high mobility for the holes are suited as the hole transfer material. Specific examples thereof include arylamine-based organic materials, conductive polymers, block copolymers having conjugated parts and non-conjugated parts together, and the like, but are not limited thereto.

The electron blocking layer is a layer capable of enhancing device lifetime and efficiency by preventing electrons injected from an electron injection layer from entering a hole injection layer after passing through a light emitting layer, and as necessary, may be formed in a proper part between the light emitting layer and the hole injection layer using known materials.

The light emitting material is a material capable of emitting light in a visible region by receiving holes and electrons from a hole transfer layer and an electron transfer layer, respectively, and binding the holes and the electrons, and is preferably a material having favorable quantum efficiency for fluorescence or phosphorescence. Specific examples thereof include 8-hydroxy-quinoline aluminum complexes (Alq₃); carbazole-based compounds; dimerized styryl compounds; BAlq; 10-hydroxybenzoquinoline-metal compounds; benzoxazole-, benzothiazole- and benzimidazole-based compounds; poly(p-phenylenevinylene) (PPV)-based polymers; spiro compounds; polyfluorene, rubrene, or the like, but are not limited thereto.

The light emitting layer may include a host material and a dopant material. The host material includes fused aromatic ring derivatives, heteroring-containing compounds or the like. Specifically, the fused aromatic ring derivative includes anthracene derivatives, pyrene derivatives, naphthalene derivatives, pentacene derivatives, phenanthrene compounds, fluoranthene compounds and the like, and the heteroring-containing compound includes carbazole derivatives, dibenzofuran derivatives, ladder-type furan compounds, pyrimidine derivatives and the like, however, the material is not limited thereto.

The dopant material includes aromatic amine derivatives, styrylamine compounds, boron complexes, fluoranthene compounds, metal complexes and the like. Specifically, the aromatic amine derivative is a fused aromatic ring derivative having a substituted or unsubstituted arylamine group and includes arylamine group-including pyrene, anthracene, chrysene, peryflanthene and the like, and the styrylamine compound is a compound in which substituted or unsubstituted arylamine is substituted with at least one arylvinyl group, and compounds unsubstituted or substituted with one, two or more substituents selected from the group consisting of an aryl group, a silyl group, an alkyl group, a cycloalkyl group and an arylamine group may be used. Specifically, styrylamine, styryldiamine, styryltriamine, styryltetramine or the like is included, however, the styrylamine compound is not limited thereto. In addition, the metal complex includes iridium complexes, platinum complexes or the like, but is not limited thereto.

The electron transfer layer is a layer that receives electrons from an electron injection layer and transfers the electrons to a light emitting layer, and as the electron transfer material, materials capable of favorably receiving electrons from a cathode, moving the electrons to a light emitting layer, and having high mobility for the electrons are suited. Specific examples thereof include Al complexes of 8-hydroxyquinoline; complexes including Alq₃; organic radical compounds; hydroxyflavon-metal complexes, or the like, but are not limited thereto. The electron transfer layer may be used together with any desired cathode material as used in the art. Particularly, examples of the suitable cathode material include common materials that have small work function, and in which an aluminum layer or a silver layer follows. Specifically, the cathode material includes cesium, barium, calcium, ytterbium and samarium, and in each case, an aluminum layer or a silver layer follows.

The electron injection layer is a layer that injects electrons from an electrode, and the electron injection material is preferably a compound that has an ability to transfer electrons, has an electron injection effect from a cathode, has an excellent electron injection effect for a light emitting layer or a light emitting material, prevents excitons generated in the light emitting layer from moving to a hole injection layer, and in addition thereto, has an excellent thin film forming ability. Specific examples thereof include fluorenone, anthraquinodimethane, diphenoquinone, thiopyran dioxide, oxazole, oxadiazole, triazole, imidazole, perylene tetracarboxylic acid, fluorenylidene methane, anthrone or the like, and derivatives thereof, metal complex compounds, nitrogen-containing 5-membered ring derivatives, and the like, but are not limited there.

The metal complex compound includes 8-hydroxyquinolinato lithium, bis(8-hydroxyquinolinato)zinc, bis(8-hydroxyquinolinato) copper, bis(8-hydroxyquinolinato)manganese, tris(8-hydroxyquinolinato)aluminum, tris(2-methyl-8-hydroxyquinolinato) aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato) (o-cresolato)gallium, bis (2-methyl-8-quinolinato) (1-naphtholato)aluminum, bis(2-methyl-8-quinolinato)(2-naphtholato)gallium and the like, but is not limited thereto.

The hole blocking layer is a layer blocking holes from reaching a cathode, and may be generally formed under the same condition as a hole injection layer. Specific examples thereof may include oxadiazole derivatives or triazole derivatives, phenanthroline derivatives, aluminum complexes and the like, but are not limited thereto.

The organic light emitting device according to the present specification may be a top-emission type, a bottom-emission type or a dual-emission type depending on the materials used.

The organic light emitting device according to the present specification may be included and used in various electronic devices. For example, the electronic device may be a display panel, a touch panel, a solar module, an illumination system or the like, but is not limited thereto.

### [Mode for the invention]

Hereinafter, the present specification will be described in detail with reference to examples in order to specifically describe the present specification. However, the examples according to the present specification may be modified to various different forms, and the scope of the present specification is not to be construed as being limited to the examples described below. Examples of the present specification are provided in order to more fully describe the present specification to those having average knowledge in the art.

### [Preparation of Polymer]

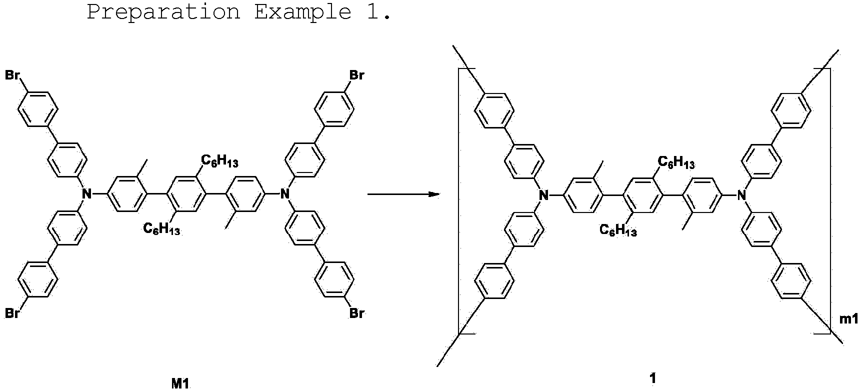

Compound M1 (1 mmol) was added to a scintillation vial and dissolved in toluene (11 mL) to prepare a first solution.

A 50 mL Schlenk tube was filled with bis(1,5-cyclooctadiene)nickel(0) (1.01 mmol). 2,2'-Dipyridyl (1.01 mmol) and 1,5-cyclooctadiene (1.01 mmol) were weighed and introduced to a scintillation vial, and dissolved in N,N'-dimethylformamide (5.5 mL) and toluene (11 mL) to prepare a second solution.

The second solution was introduced to the Schlenk tube, and stirred for 30 minutes at 50°C. The first solution was further added to the Schlenk tube, and the result was stirred for 180 minutes at 50°C. Then, the Schlenk tube was cooled to room temperature, and then poured into HCl/methanol (5% v/v, concentrated HCl). After stirring for 45 minutes, a polymer was collected by vacuum filtration, and dried under high vacuum. The polymer was dissolved in toluene (1% wt/v), and passed through a column containing basic aluminum oxide (6 g) layered on silica gel (6 g). The polymer/toluene filtrate was concentrated (5% wt/v toluene), and triturated with acetone. Polymer 1 was obtained in a 60% yield.

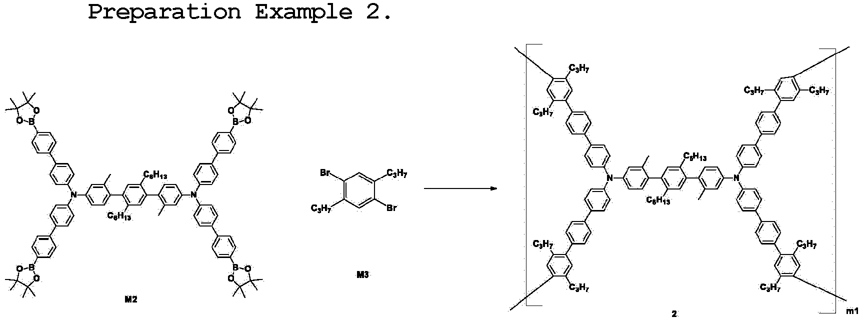

Polymer 2 was prepared in the same manner as in the method for preparing Polymer 1 except that Compounds M2 and M3 were used instead of Compound M1.

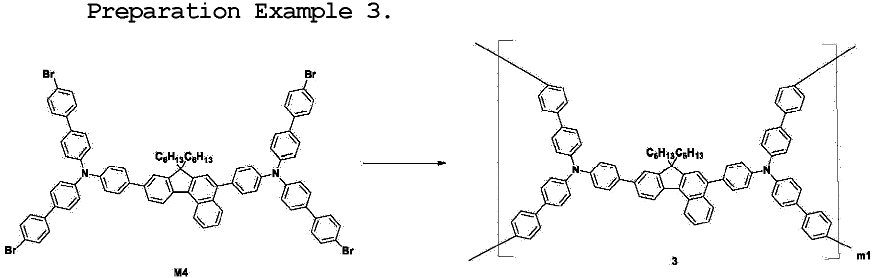

Polymer 3 was prepared in the same manner as in the method for preparing Polymer 1 except that Compound M4 was used instead of Compound M1.

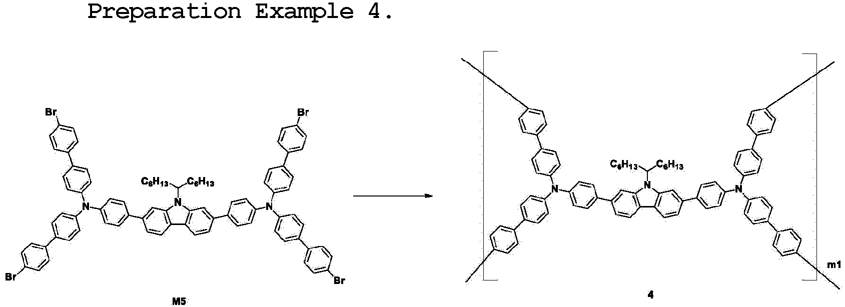

Polymer 4 was prepared in the same manner as in the method for preparing Polymer 1 except that Compound M5 was used instead of Compound M1.

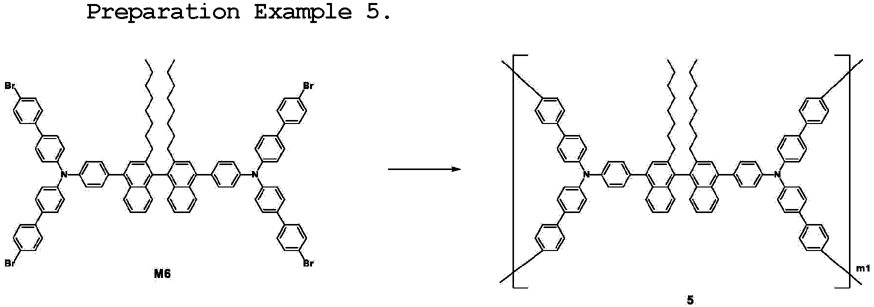

Polymer 5 was prepared in the same manner as in the method for preparing Polymer 1 except that Compound M6 was used instead of Compound M1.

Number average molecular weight (Mn), weight average molecular weight (Mw) and molecular weight distribution (PDI) values, and a viscosity value of each of Polymers 1 to 5 prepared in Preparation Examples 1 to 5 are described in the following Table 1.

Specifically, the number average molecular weight (Mn), the weight average molecular weight (Mw) and the molecular weight distribution (PDI) were measured using GPC (gel permeation chromatography).

The viscosity was measured using the sample (1 mL) including the polymer (2 wt%) (solvent: toluene) using a Brookfield viscometer CV Nest Cone & Plate Rheometer while maintaining 25°C.

**[Table 1]**

| Polyme r | Mn (g/mol) | Mw (g/mol) | PDI | Viscosity (cP, Room Temperature) |
|---|---|---|---|---|
| 1 | 23,600 | 84,300 | 3.57 | 5.4 |
| 2 | 32,100 | 105,000 | 3.27 | 6.0 |
| 3 | 21,000 | 65,700 | 3.12 | 4.7 |
| 4 | 27,300 | 86,200 | 3.16 | 5.4 |
| 5 | 22,500 | 76,400 | 3.39 | 6.1 |

### [Experimental Example]

### Example 1.

A glass substrate on which ITO was deposited as a thin film to a thickness of 1,500 Å was ultrasonic cleaned for 10 minutes using an acetone solvent. After that, the substrate was placed in detergent-dissolved distilled water, and after cleaning for 10 minutes with ultrasonic waves, ultrasonic cleaning was repeated twice using distilled water for 10 minutes. After the cleaning with distilled water was finished, the substrate was ultrasonic cleaned with a solvent of isopropyl alcohol for 10 minutes, and then dried. After that, the substrate was transferred to a glove box.

On the transparent ITO electrode prepared as above, a 2 wt% cyclohexanone ink of Compound A: Chemical Formula B (weight ratio of 8:2) was spin coated (4000 rpm) on the ITO surface, and heat treated for 30 minutes at 230°C to form a hole injection layer to a thickness of 40 nm.

A toluene solution including Polymer 1 in 0.8 wt% was prepared, and then spin coated on the hole injection layer to form a hole transfer layer having a thickness of 100 nm.

After that, a light emitting layer was formed on the hole transfer layer through a solution process using the following Compound C and the following Compound D in a weight ratio of 9:1. The following Compound E was vacuum deposited on the light emitting layer to form an electron injection and transfer layer having a thickness of 40 nm. On the electron injection and transfer layer, LiF having a thickness of 0.5 nm and aluminum having a thickness of 100 nm were consecutively deposited to form a cathode.

In the above-mentioned process, the deposition rates of the organic materials were maintained at 0.4 Å/sec to 1.0 Å/sec, the deposition rates of the LiF and the aluminum were maintained at 0.3 Å/sec and 2 Å/sec, respectively, and the degree of vacuum during the deposition was maintained at 2×10⁻⁸ torr to 5×10⁻⁶ torr.

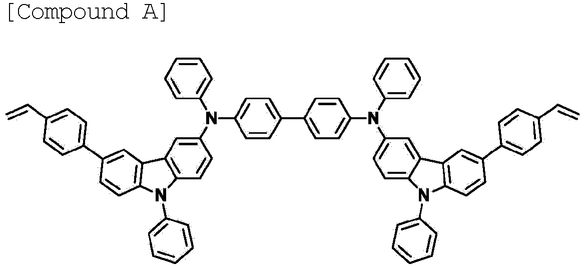

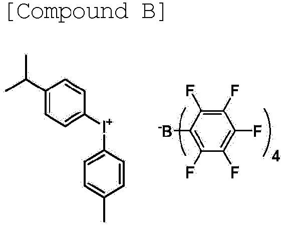

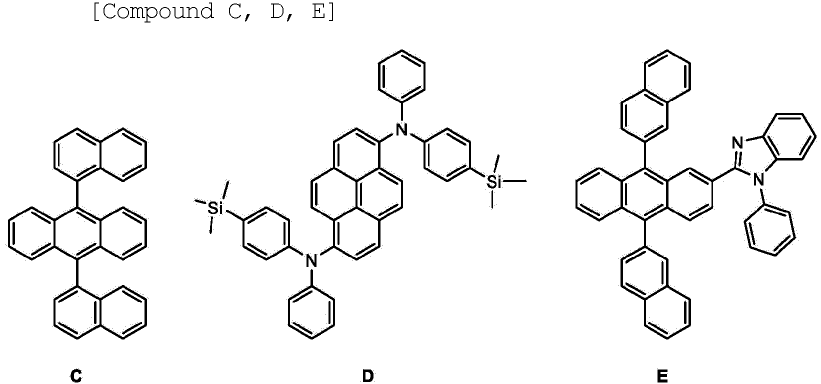

### Examples 2 to 5 and Comparative Examples 1 and 2

Organic light emitting devices were manufactured in the same manner as in Example 1 except that polymers described in the following Table 3 were each used instead of Polymer 1 as the hole transfer layer material in Example 1.

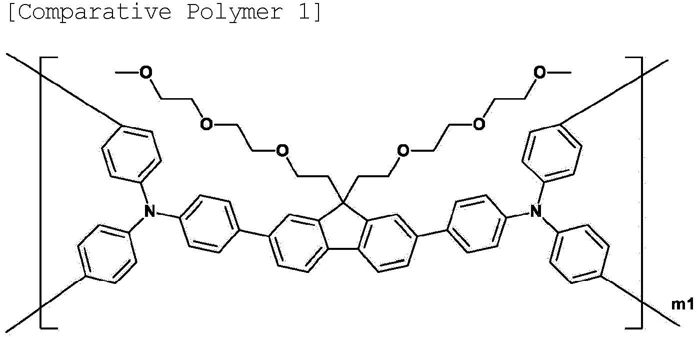

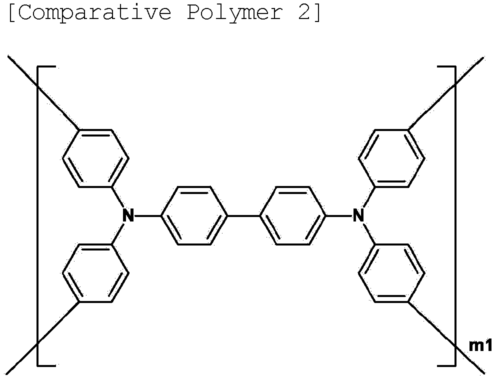

**[Table 2]**

| Polymer | Mn (g/mol) | Mw (g/mol) | PDI |
|---|---|---|---|
| Comparative Polymer 1 | 23600 | 84900 | 3.6 |
| Comparative Polymer 2 | 4890 | 16100 | 3.29 |

For the organic light emitting devices manufactured in Examples 1 to 5 and Comparative Examples 1 and 2, driving voltage and external quantum efficiency were measured at current density of 10 mA/cm², and a time (lifetime) taken for luminance to become 95% with respect to initial luminance (1000 nit) at the current density was measured. The results are shown in the following Table 3.

**[Table 3]**

| Experimental Example | Polymer | Volt (V) | J (mA/cm² ) | EQE (%) | T95 (h) |
|---|---|---|---|---|---|
| Example 1 | 1 | 4.31 | 10 | 5.67 | 167 |
| Example 2 | 2 | 4.42 | 10 | 5.99 | 173 |
| Example 3 | 3 | 4.30 | 10 | 5.63 | 171 |
| Example 4 | 4 | 4.40 | 10 | 5.96 | 151 |
| Example 5 | 5 | 4.29 | 10 | 5.58 | 125 |
| Comparative Example 1 | Comparative Polymer 1 | 5.31 | 10 | 3.96 | 10 |
| Comparative Example 2 | Comparative Polymer 2 | 4.75 | 10 | 0.66 | 8 |

From Table 3, it was identified that Examples 1 to 5 of the present application had lower device driving voltage and superior efficiency and lifetime compared to Comparative Examples 1 and 2 using Comparative Polymer 1 or Comparative Polymer 2 having a different structure from the polymer of the present application as the hole transfer layer material.

Specifically, in Comparative Polymer 1, the substituent of the fluorene group includes O. In this case, hydrophilic properties are provided to the polymer, and, as the solvent of the solution process, polar solvents need to be mainly selected, which has a limit in terms of solvent diversity compared the polymer of the present disclosure. In addition, O of the substituent of Comparative Polymer 1 readily combines with moisture during the process decreasing process efficiency, and as a result, the device using Comparative Polymer 1 had significantly reduced voltage, efficiency and lifetime properties.

Comparative Polymer 2 has a structure in which the L portion of Chemical Formula 1 of the present disclosure is a direct bond, and the device using the same had significantly reduced voltage, efficiency and lifetime properties.

## Claims

1. A polymer including a unit represented by the following Chemical Formula 1: 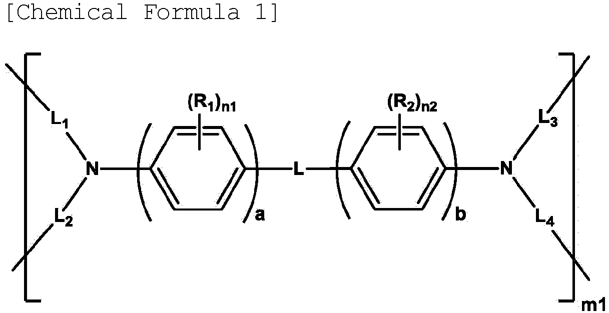 wherein, in Chemical Formula 1,
R₁ and R₂ are the same as or different from each other, and each independently hydrogen; deuterium; a halogen group; a substituted or unsubstituted silyl group; a substituted or unsubstituted alkyl group; a substituted or unsubstituted alkoxy group; a substituted or unsubstituted aryl group; or a substituted or unsubstituted heteroaryl group;
L is an arylene group substituted with a C₁-C₃₀ alkyl group; or a heteroarylene group substituted with a C₁-C₃₀ alkyl group;
L₁ to L₄ are the same as or different from each other, and each independently a substituted or unsubstituted arylene group; or a substituted or unsubstituted heteroarylene group;
a and b are each 1 or 2, and when a and b are 2, substituents in the two parentheses are the same as or different from each other;
n1 and n2 are each an integer of 0 to 4, and when n1 and n2 are 2 or greater, substituents in the two or more parentheses are the same as or different from each other; and
m1 is, as a repetition number of the unit, an integer of 1 to 10,000.

2. The polymer of Claim 1,
wherein the L is a phenylene group substituted with a C₁-C₃₀ alkyl group; a benzofluorenylene group substituted with a C₁-C₃₀ alkyl group; a binaphthylene group substituted with a C₁-C₃₀ alkyl group; a divalent dibenzofuran group substituted with a C₁-C₃₀ alkyl group; a divalent dibenzothiophene group substituted with a C₁-C₃₀ alkyl group; or a divalent carbazolyl group substituted with a C₁-C₃₀ alkyl group.

3. The polymer of Claim 1, wherein L₁ to L₄ are the same as or different from each other, and each independently a substituted or unsubstituted biphenylylene group; or a substituted or unsubstituted terphenylene group.

4. The polymer of Claim 1, wherein the unit represented by Chemical Formula 1 is any one selected from among the following structures: 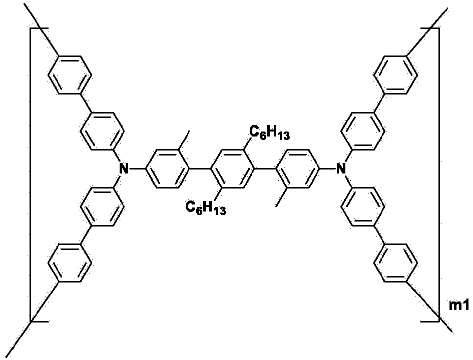 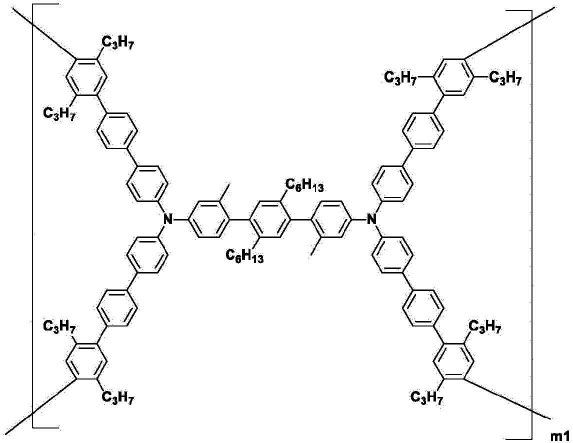 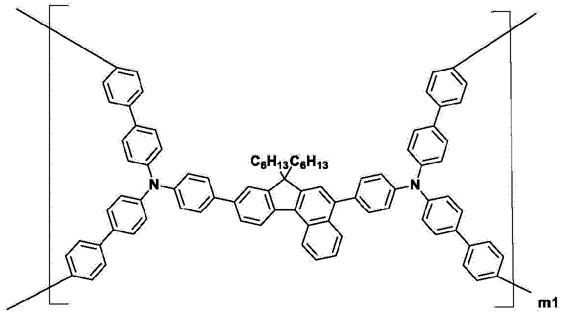 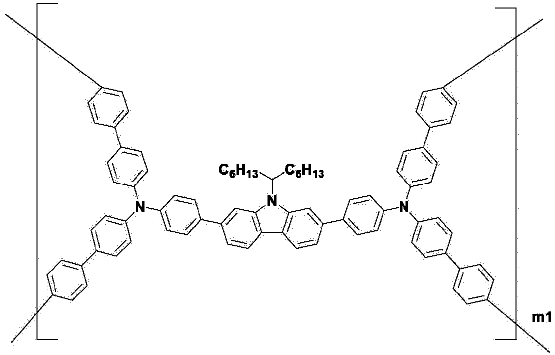 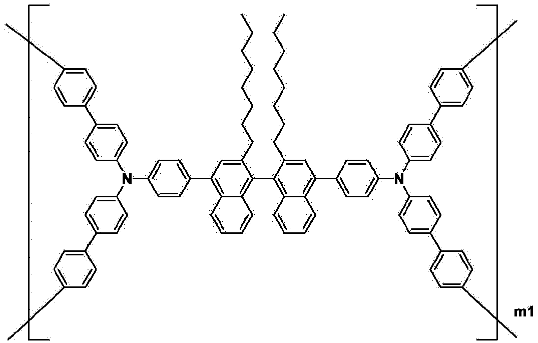 in the structures,
m1 is, as a repetition number of the unit, an integer of 1 to 10,000.

5. A coating composition comprising the polymer of any one of Claims 1 to 4.

6. An organic light emitting device comprising:
a first electrode;
a second electrode; and
an organic material layer provided between the first electrode and the second electrode,
wherein the organic material layer includes the polymer of any one of Claims 1 to 4.

7. The organic light emitting device of Claim 6, wherein the organic material layer including the polymer is an electron blocking layer; a hole transfer layer; a hole injection layer; or a hole injection and transfer layer.

8. The organic light emitting device of Claim 6, wherein the organic material layer including the polymer is a hole blocking layer; an electron transfer layer; an electron injection layer; or an electron injection and transfer layer.

9. A method for manufacturing an organic light emitting device, the method comprising:
preparing a first electrode;
forming one or more organic material layers on the first electrode; and
forming a second electrode on the one or more organic material layers,
wherein the forming of one or more organic material layers includes forming the organic material layers using the coating composition of Claim 5.

10. The method for manufacturing an organic light emitting device of Claim 9, wherein the forming of organic material layers using the coating composition includes coating the coating composition; and heat treating or light treating the coated coating composition.

## Patentansprüche

1. Polymer, das eine durch die folgende chemische Formel 1 dargestellte Einheit einschließt: 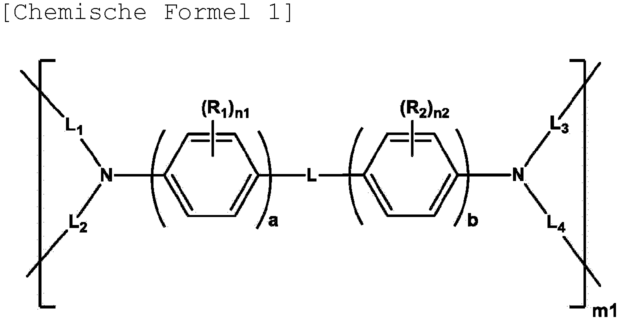 worin, in der chemischen Formel 1,
R₁ und R₂ gleich oder verschieden voneinander sind und jeweils unabhängig Wasserstoff; Deuterium; eine Halogengruppe; eine substituierte oder unsubstituierte Silylgruppe; eine substituierte oder unsubstituierte Alkylgruppe; eine substituierte oder unsubstituierte Alkoxygruppe; eine substituierte oder unsubstituierte Arylgruppe; oder eine substituierte oder unsubstituierte Heteroarylgruppe sind;
L ist eine Arylengruppe, die mit einer C₁-C₃₀-Alkylgruppe substituiert ist; oder eine Heteroarylengruppe, die mit einer C₁-C₃₀-Alkylgruppe substituiert ist;
L₁ bis L₄ sind gleich oder verschieden voneinander und jeweils unabhängig eine substituierte oder unsubstituierte Arylengruppe; oder eine substituierte oder unsubstituierte Heteroarylengruppe;
a und b sind jeweils 1 oder 2, und wenn a und b 2 sind, sind die Substituenten in den beiden Klammern gleich oder verschieden voneinander;
n1 und n2 sind jeweils eine ganze Zahl von 0 bis 4, und wenn n1 und n2 2 oder größer sind, sind die Substituenten in den zwei oder mehr Klammern gleich oder verschieden voneinander; und
m1 ist, als Wiederholungszahl der Einheit, eine ganze Zahl von 1 bis 10.000.

2. Das Polymer nach Anspruch 1,
wobei L eine mit einer C₁-C₃₀-Alkylgruppe substituierte Phenylengruppe; eine mit einer C₁-C₃₀-Alkylgruppe substituierte Benzofluorenylengruppe; eine mit einer C₁-C₃₀-Alkylgruppe substituierte Binaphthylengruppe; eine mit einer C₁-C₃₀-Alkylgruppe substituierte zweiwertige Dibenzofurangruppe; eine mit einer C₁-C₃₀-Alkylgruppe substituierte zweiwertige Dibenzothiophengruppe; oder eine mit einer C₁-C₃₀-Alkylgruppe substituierte zweiwertige Carbazolylgruppe ist.

3. Polymer nach Anspruch 1, wobei L₁ bis L₄ gleich oder verschieden voneinander sind und jeweils unabhängig eine substituierte oder unsubstituierte Biphenylylengruppe oder eine substituierte oder unsubstituierte Terphenylengruppe sind.

4. Polymer nach Anspruch 1, wobei die durch die chemische Formel 1 dargestellte Einheit aus den folgenden Strukturen ausgewählt ist: 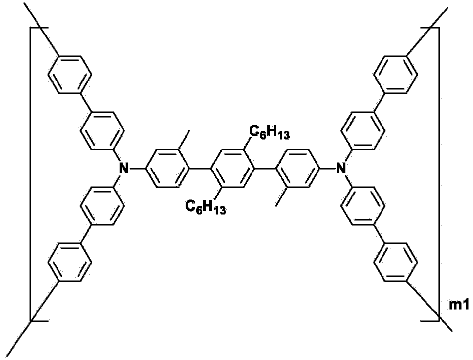 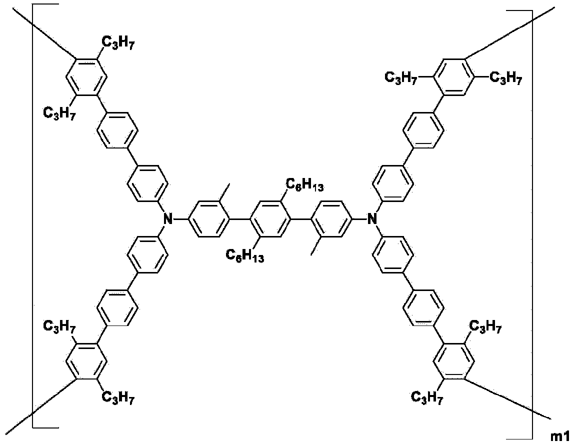 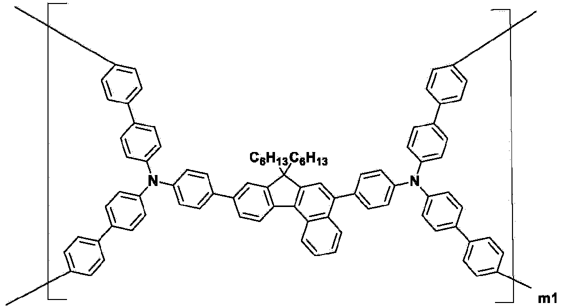 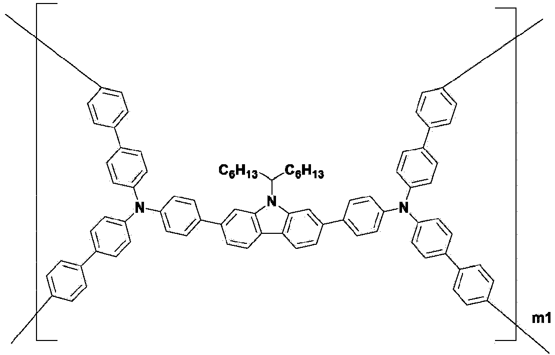 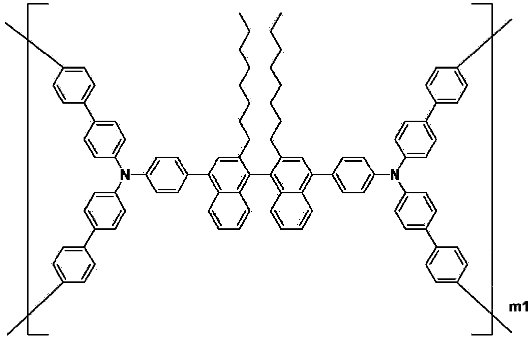 in den Strukturen,
ist m1 als Wiederholungszahl der Einheit eine ganze Zahl von 1 bis 10.000.

5. Beschichtungszusammensetzung, umfassend das Polymer nach mindestens einem der Ansprüche 1 bis 4.

6. Organische lichtemittierende Vorrichtung, umfassend:
eine erste Elektrode;
eine zweite Elektrode; und
eine organische Materialschicht, die zwischen der ersten Elektrode und der zweiten Elektrode angeordnet ist,
wobei die organische Materialschicht das Polymer nach mindestens einem der Ansprüche 1 bis 4 einschließt.

7. Organische lichtemittierende Vorrichtung nach Anspruch 6, wobei die organische Materialschicht, die das Polymer einschließt, eine Elektronensperrschicht, eine Lochtransferschicht, eine Lochinjektionsschicht oder eine Lochinjektions- und -transferschicht ist.

8. Organische lichtemittierende Vorrichtung nach Anspruch 6, wobei die organische Materialschicht, die das Polymer einschließt, eine Lochsperrschicht, eine Elektronentransferschicht, eine Elektroneninjektionsschicht oder eine Elektroneninjektions- und -transferschicht ist.

9. Verfahren zur Herstellung einer organischen lichtemittierenden Vorrichtung, wobei das Verfahren folgendes umfasst:
Herstellen einer ersten Elektrode;
Ausbilden von einer oder mehreren organischen Materialschichten auf der ersten Elektrode; und
Ausbilden von einer zweiten Elektrode auf der einen oder den mehreren organischen Materialschichten,
wobei das Ausbilden von einer oder mehreren organischen Materialschichten das Ausbilden der organischen Materialschichten unter Verwendung der Beschichtungszusammensetzung nach Anspruch 5 einschließt.

10. Verfahren zur Herstellung einer organischen lichtemittierenden Vorrichtung nach Anspruch 9, wobei das Ausbilden von organischen Materialschichten unter Verwendung der Beschichtungszusammensetzung Beschichten der Beschichtungszusammensetzung und Wärme- oder Lichtbehandlung der beschichteten Beschichtungszusammensetzung umfasst.

## Revendications

1. Polymère incluant une unité représentée par la Formule chimique 1 suivante : 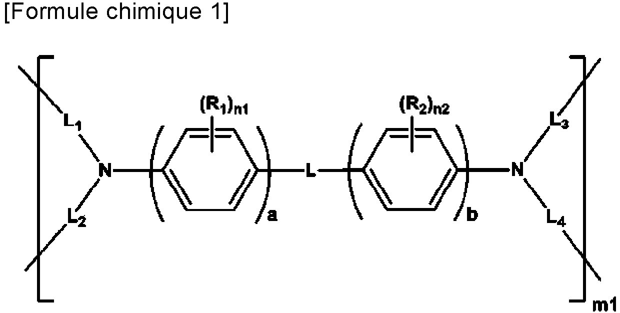 dans lequel, dans la Formule chimique 1,
R₁ et R₂ sont identiques l'un à l'autre ou différents l'un de l'autre, et chacun indépendamment hydrogène ; deutérium ; un groupe halogène ; un groupe silyle substitué ou non substitué ; un groupe alkyle substitué ou non substitué ; un groupe alcoxy substitué ou non substitué ; un groupe aryle substitué ou non substitué ; ou un groupe hétéroaryle substitué ou non substitué ;
L est un groupe arylène substitué par un groupe alkyle en C₁-C₃₀ ; ou un groupe hétéroarylène substitué par un groupe alkyle en C₁-C₃₀ ;
L₁ à L₄ sont identiques l'un à l'autre ou différents l'un de l'autre, et sont chacun indépendamment un groupe arylène substitué ou non substitué ; ou un groupe hétéroarylène substitué ou non substitué ;
a et b sont chacun 1 ou 2, et lorsque a et b sont 2, des substituants dans les deux parenthèses sont identiques l'un à l'autre ou différents l'un de l'autre ;
n1 et n2 sont chacun un nombre entier de 0 à 4, et lorsque n1 et n2 sont 2 ou plus, des substituants dans les deux parenthèses ou plus sont identiques l'un à l'autre ou différents l'un de l'autre ; et
m1 est, en tant que nombre de répétitions de l'unité, un nombre entier de 1 à 10 000.

2. Polymère selon la revendication 1,
dans lequel le L est un groupe phénylène substitué par un groupe alkyle en C₁-C₃₀ ; un groupe benzofluorénylène substitué par un groupe alkyle en C₁-C₃₀ ; un groupe binaphtylène substitué par un groupe alkyle en C₁-C₃₀ ; un groupe dibenzofurane divalent substitué par un groupe alkyle en C₁-C₃₀ ; un groupe dibenzothiophène divalent substitué par un groupe alkyle en C₁-C₃₀ ; ou un groupe carbazolyle divalent substitué par un groupe alkyle en C₁-C₃₀.

3. Polymère selon la revendication 1, dans lequel L₁ à L₄ sont identiques l'un à l'autre ou différents l'un de l'autre, et chacun indépendamment un groupe biphénylylène substitué ou non substitué ; ou un groupe terphénylène substitué ou non substitué.

4. Polymère selon la revendication 1, dans lequel l'unité représentée par la Formule chimique 1 est l'une quelconque parmi les structures suivantes : 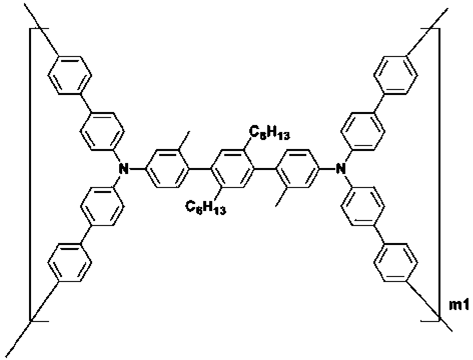 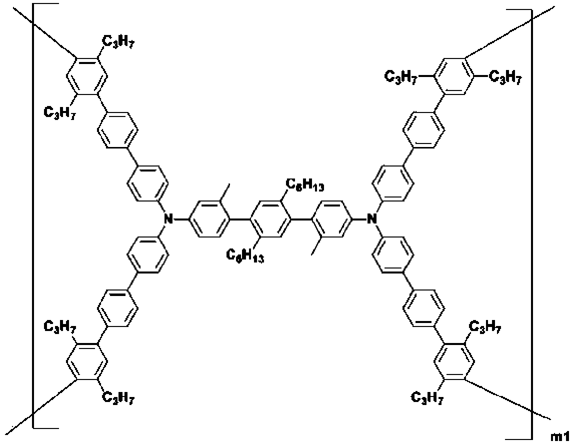 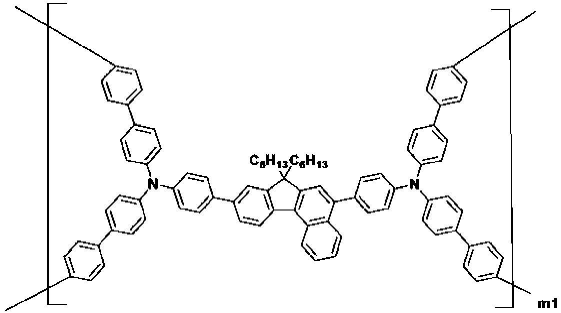 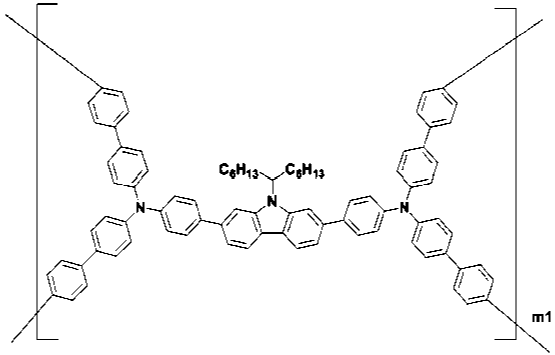 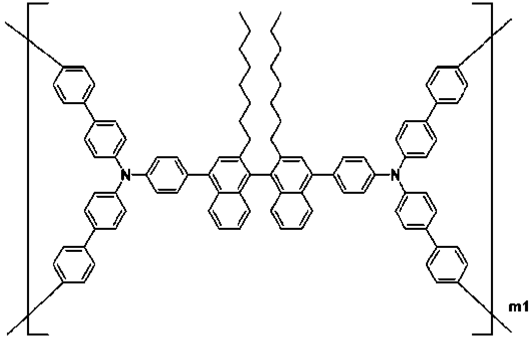 dans les structures,
m1 est, en tant que nombre de répétitions de l'unité, un nombre entier de 1 à 10 000.

5. Composition de revêtement comprenant le polymère selon l'une quelconque des revendications 1 à 4.

6. Dispositif électroluminescent organique comprenant :
une première électrode ;
une seconde électrode ; et
une couche de matériau organique placée entre la première électrode et la seconde électrode,
dans lequel la couche de matériau organique inclut le polymère selon l'une quelconque des revendications 1 à 4.

7. Dispositif électroluminescent organique selon la revendication 6, dans lequel la couche de matériau organique incluant le polymère est une couche de blocage des électrons ; une couche de transfert de trous ; une couche d'injection de trous ; ou une couche d'injection et de transfert de trous.

8. Dispositif électroluminescent organique selon la revendication 6, dans lequel la couche de matériau organique incluant le polymère est une couche de blocage des trous ; une couche de transfert d'électrons ; une couche d'injection d'électrons ; ou une couche d'injection et de transfert d'électrons.

9. Procédé de fabrication d'un dispositif électroluminescent organique, le procédé comprenant :
la préparation d'une première électrode ;
la formation d'une ou plusieurs couches de matériau organique sur la première électrode ; et
la formation d'une seconde électrode sur les une ou plusieurs couches de matériau organique,
dans lequel la formation d'une ou plusieurs couches de matériau organique inclut le fait de former les couches de matériau organique en utilisant la composition de revêtement de la revendication 5.

10. Procédé de fabrication d'un dispositif électroluminescent organique selon la revendication 9, dans lequel la formation de couches de matériau organique en utilisant la composition de revêtement inclut le dépôt de la composition de revêtement ; et le traitement thermique ou le traitement lumineux de la composition de revêtement déposée.
